# DEMANDE DE BREVET EUROPEEN

(11) **EP 4 580 353 A1**
(43) Date de publication de la demande: **02.07.2025**
(21) Numéro de dépôt: 24222631.4
(22) Date de dépôt: 20.12.2024
(51) Int. Cl.: H10H 29/01, H10H 29/14, H10H 29/34, H10H 29/37, H10H 29/851, H10H 20/818, H10H 20/01, H10H 29/02, H10H 29/80, H10H 29/85, H10H 29/855, H10H 29/856, H01L 25/16, H10H 20/813, H10H 20/819

(54) **PROCÉDÉ DE FABRICATION D'UN DISPOSITIF OPTOÉLECTRONIQUE ET ÉCRAN D'AFFICHAGE OBTENU PAR CE PROCÉDÉ**

(30) Priorité: 26.12.2023 FR 2315318
(71) Demandeur: Aledia, 38800 Champagnier (FR)
(72) Inventeur: LINCHENEAU, Christophe, 38430 MOIRANS (FR); ROBIN, Ivan-Christophe, 38000 GRENOBLE (FR)
(74) Mandataire: Cabinet Beaumont

(57) **Abrégé**

La présente demande concerne un procédé de fabrication d'un dispositif optoélectronique comprenant les étapes suivantes, dans l'ordre:

a) fabriquer des circuits de pixel d'affichage (12) comprenant chacun une face (18) d'émission, et sur ladite face (18), des murs (22) délimitant au moins une cavité (24);

b) fixer lesdits circuits de pixel d'affichage (12) à un support (30); et

c) remplir l'au moins une cavité (24) de chaque circuit de pixel d'affichage (12) par un premier matériau de remplissage pour former un premier module de conversion de couleur (32) dans ladite cavité (24).

La présente demande concerne également un écran d'affichage (40) obtenu par le procédé de fabrication précédemment détaillé.

## Description

### Domaine technique

La présente demande concerne un procédé de fabrication d'un dispositif optoélectronique, notamment un écran d'affichage ou un dispositif de projection d'images, comprenant des modules de conversion de couleur.

### Technique antérieure

Un pixel d'une image correspond à l'élément unitaire de l'image affichée ou captée par un dispositif optoélectronique. On appelle pixel d'affichage du dispositif optoélectronique l'élément du dispositif optoélectronique permettant l'affichage d'un pixel d'image. Un pixel d'affichage d'un dispositif optoélectronique tel qu'un écran d'affichage d'images couleur ou un dispositif de projection d'images couleur comprend en général pour l'affichage d'un pixel d'image au moins trois composants, appelés sous-pixels d'affichage, qui émettent chacun un rayonnement lumineux sensiblement dans une seule couleur (par exemple, le rouge, le vert et le bleu). La superposition des rayonnements émis par les sous-pixels d'affichage fournit à l'observateur la sensation colorée correspondant au pixel d'image de l'image affichée.

Un sous-pixel d'affichage peut comprendre une source lumineuse, notamment une diode électroluminescente, recouverte d'un module de conversion de couleurs par exemple sous forme d'un bloc photoluminescent. Le bloc photoluminescent comprend des luminophores ou des particules d'au moins un matériau photoluminescent configurés, lorsqu'ils sont excités par la lumière émise par la diode électroluminescente associée, pour émettre de la lumière à une longueur d'onde différente de la longueur d'onde de la lumière émise par la diode électroluminescente associée. Les particules photoluminescentes peuvent se présenter sous forme de boîtes quantiques.

Il peut être prévu des murs entourant des sous-pixels comprenant ou ne comprenant pas des modules de conversion de couleur et qui réfléchissent ou absorbent les rayonnements émis par les diodes électroluminescentes mais également les modules de conversion de couleur. Les murs réduisent alors la diaphonie entre sous-pixels adjacents. Un autre intérêt des murs est de servir de moyen de confinement pour le dépôt des matériaux constitutifs des modules de conversion de couleur.

Un exemple de procédé de fabrication d'un dispositif optoélectronique, notamment un écran d'affichage, comprend la fabrication des pixels d'affichage sur une plaque semiconductrice, la découpe de la plaque pour séparer les pixels d'affichage, et le transfert et la fixation des pixels d'affichage à un support de l'écran d'affichage. Un inconvénient est que les procédés de découpe des pixels d'affichage et/ou de transfert des pixels d'affichage depuis la plaque jusque sur le support et/ou de fixation des pixels d'affichage au support peuvent requérir des étapes hautement énergétiques et/ou des températures supérieures à 200 °C et que les propriétés de conversion optique des modules de conversion de couleur peuvent se dégrader lors de ces étapes. Le bilan thermique du procédé de fabrication des pixels d'affichage et/ou de fixation des pixels d'affichage au support peut être d'autant plus défavorable pour les modules de conversion de couleur lorsque le pixel d'affichage correspond à un pixel intelligent, c'est-à-dire lorsqu'il comprend un circuit électronique de commande des sources électroluminescentes des sous-pixels d'affichage.

### Résumé de l'invention

Un mode de réalisation pallie tout ou partie des inconvénients des dispositifs optoélectroniques à modules de conversion de couleur connus.

Un mode de réalisation prévoit un procédé de fabrication d'un dispositif optoélectronique comprenant les étapes suivantes, dans l'ordre :
a) fabriquer des circuits de pixel d'affichage comprenant chacun une face d'émission, et sur la face, des murs délimitant au moins une cavité ;
b) fixer les circuits de pixel d'affichage à un support ; et
c) remplir l'au moins une cavité de chaque circuit de pixel d'affichage par un premier matériau de remplissage pour former un premier module de conversion de couleur dans la cavité.

Les murs, qui entourent les premiers modules de conversion de couleur permettent, de façon avantageuse, de réduire la diaphonie optique entre les sous-pixels d'affichage adjacents du circuit de pixel d'affichage. Le fait de former les premiers modules de conversion de couleur après la mise en place des circuits de pixel d'affichage sur le support permet de façon avantageuse de pouvoir sélectionner le premier matériau de remplissage à utiliser à une étape tardive de la fabrication du dispositif optoélectronique. Un autre avantage de former les premiers modules de conversion de couleur après la mise en place des circuits de pixel d'affichage sur le support est que les premiers modules de conversion de couleur ne sont pas exposés à des températures élevées qui peuvent être présentes notamment lors de la fixation des circuits de pixel d'affichage au support. Un autre avantage de former les premiers modules de conversion de couleur après la mise en place des circuits de pixel d'affichage sur le support est qu'il n'est pas nécessaire de prévoir une protection des premiers modules de conversion de couleur qui serait nécessaire si les premiers modules de conversion de couleur étaient formés avant la séparation des circuits de pixel d'affichage ou plus généralement avant la mise en place des circuits de pixel d'affichage sur le support.

Un avantage de former les murs avant l'étape de transfert des circuits de pixel d'affichage sur le support est que cela rend plus facile la réalisation des murs par des étapes de fabrication comprenant des étapes de photolithographie car les circuits de pixel d'affichage n'ont pas encore subi de transfert et sont donc correctement alignés sur la plaque. En effet, le transfert induit de potentiels défauts de décalages ou rotation de positionnement qui rendent la mise en oeuvre d'étapes de photolithographie pour former les murs impossible, complexe ou imprécise car devant prendre en compte des degrés d'erreur multiples.

Selon un mode de réalisation, le premier matériau de remplissage comprend des boîtes quantiques. Les propriétés de conversion optique des boîtes quantiques pouvant se dégrader lorsque les boîtes quantiques sont exposées à des températures élevées, le fait de former les premiers modules de conversion de couleur après la mise en place des circuits de pixel d'affichage sur le support permet de façon avantageuse de ne pas exposer les boîtes quantiques à des températures élevées.

Selon un mode de réalisation, le procédé comprend, après l'étape c), l'étape de formation d'un film de protection recouvrant complètement chaque circuit de pixel d'affichage et le support entre les circuits de pixel d'affichage. Le film peut de façon avantageuse être étanche à l'eau et à l'oxygène pour protéger les premiers modules de conversion de couleur. Le film peut avantageusement être déposé simplement sur l'ensemble du dispositif optoélectronique juste après le dépôt des modules de conversion de couleur et éviter ainsi une détérioration de ceux-ci.

Selon un mode de réalisation, l'étape a) comprend la formation de plusieurs exemplaires du circuit de pixel d'affichage sur une plaque et la découpe de la plaque pour séparer les circuits de pixel d'affichage. Ceci permet avantageusement de former les murs en utilisant des technologies classiques de fabrication en microélectronique.

Selon un mode de réalisation, à l'étape a), la formation des murs comprend des étapes de photolithographie. Ceci permet, de façon avantageuse, de réaliser des murs dont l'épaisseur peut être de l'ordre du micromètre ou inférieure au micromètre. De façon avantageuse, des étapes de photolithographie identiques peuvent être mises en oeuvre alors que les circuits de pixel d'affichage peuvent être destinés à des dispositifs électroniques différents, par exemple à des types d'écrans d'affichage différents. En particulier, les mêmes masques peuvent être utilisés pour former les murs des circuits de pixel d'affichage, même si les circuits de pixel d'affichage peuvent être destinés à des dispositifs électroniques différents.

Selon un mode de réalisation, le procédé comprend, à l'étape a), le remplissage des cavités par un deuxième matériau de remplissage et, après l'étape b) et avant l'étape c), le retrait du deuxième matériau de remplissage des cavités. Ceci permet de façon avantageuse d'obtenir des blocs temporaires dans les cavités qui permettent de consolider les cavités pour des étapes ultérieures du procédé de fabrication La présence des blocs temporaires dans les cavités permet en outre de façon avantageuse l'obtention d'un circuit de pixel d'affichage ayant une face supérieure plane, ce qui facilite l'utilisation d'un préhenseur pour le transfert des circuits de pixel d'affichage de la plaque au support.

Selon un mode de réalisation, à l'étape c), le remplissage de l'au moins une cavité de chaque circuit de pixel d'affichage par le premier matériau de remplissage est réalisé par impression par jet d'encre, par impression par jet d'aérosol, ou par impression par extrusion. De façon avantageuse, les procédés de remplissage des cavités sont adaptés à compenser les écarts entre la position et/ou l'orientation réelles des circuits de pixel d'affichage et la position et/ou l'orientation idéales souhaitées. Ce ne serait pas le cas des procédés de fabrication des murs si les murs étaient fabriqués après le transfert des circuits de pixel d'affichage sur le support.

Selon un mode de réalisation, à l'étape a), les murs délimitent au moins trois cavités pour chaque circuit de pixel d'affichage.

Selon un mode de réalisation, les murs délimitent au moins deux cavités pour chaque circuit de pixel d'affichage, et l'étape c) comprend le remplissage d'au moins l'une des cavités de chaque circuit de pixel d'affichage par un troisième matériau de remplissage, différent du premier matériau de remplissage, pour former un deuxième module de conversion de couleur dans la cavité.

Selon un mode de réalisation, le rapport entre la hauteur et l'épaisseur des murs est dans la plage de 0,5 à 50.

Selon un mode de réalisation, le procédé comprend, à l'étape a), la formation de diodes électroluminescentes pour chaque circuit de pixel d'affichage.

Selon un mode de réalisation, le support comprend une dalle munie de pistes électriques de connexion, le procédé comprenant, à l'étape b), le transfert des circuits de pixel d'affichage sur la dalle, les circuits de pixel d'affichage étant fixés aux pistes électriques de connexion, le pas entre les circuits de pixel d'affichage sur la dalle étant différent du pas entre les circuits de pixel d'affichage sur la plaque.

Selon un mode de réalisation, le dispositif optoélectronique est un écran d'affichage.

Un mode de réalisation prévoit également un écran d'affichage obtenu par le procédé de fabrication décrit précédemment.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 et la figure 2 sont respectivement une vue en coupe de côté et une vue de dessus, partielles et schématiques, d'une structure obtenue à une étape d'un mode de réalisation d'un procédé de fabrication d'un écran d'affichage ;
la figure 3, la figure 4, et la figure 5 sont des vues en coupe de côté, partielles et schématiques, de structures obtenues à d'autres étapes du mode de réalisation du procédé de fabrication d'un écran d'affichage ;
la figure 6 est une vue de dessus, partielle et schématique, de la structure de la figure 5 ;
la figure 7, la figure 8, et la figure 9 sont des vues en coupe de côté, partielles et schématiques, de structures obtenues à d'autres étapes du mode de réalisation du procédé de fabrication d'un écran d'affichage ;
la figure 10 et la figure 11 sont des vues en coupe de côté, partielle et schématique, de la structure obtenue au cours d'une étape de transfert selon deux modes de réalisation ;
la figure 12 est une vue en coupe de côté, partielle et schématique, de la structure au cours d'une étape de remplissage de cavités ;
la figure 13 est une vue de dessus, partielle et schématique, d'un écran d'affichage illustrant un positionnement incorrect des pixels d'affichage ;
la figure 14 est une vue en coupe, partielle et schématique, d'un mode de réalisation d'un dispositif optoélectronique à diodes électroluminescentes et à blocs photoluminescents ; et
la figure 15, la figure 16, et la figure 17 sont des vues en coupe, partielles et schématiques, de modes de réalisation d'une diode électroluminescente.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures ou à un pixel d'affichage dans une position normale d'utilisation.

Sauf précision contraire, les expressions "environ", "approximativement", "sensiblement", et "de l'ordre de" signifient à 10 % près, de préférence à 5 % près.

La transmittance d'une couche correspond au rapport entre l'intensité du rayonnement sortant de la couche par une face de sortie et l'intensité du rayonnement entrant dans la couche par une face d'entrée opposée à la face de sortie. Dans la suite de la description, une couche ou un film est dit opaque à un rayonnement lorsque la transmittance du rayonnement au travers de la couche ou du film est inférieure à 10 %. Dans la suite de la description, une couche ou un film est dit transparent à un rayonnement lorsque la transmittance du rayonnement au travers de la couche ou du film est supérieure à 10 %.

Dans la suite de la description, un film ou une couche est dit étanche à l'eau lorsque la perméabilité du film ou de la couche à l'eau à 40 °C est inférieure à 1.10⁻¹g/ (m²*jour). La perméabilité à l'eau peut être mesurée selon la méthode ASTM F1249 intitulée "Standard Test Method for Water Vapor Transmission Rate Through Plastic Film and Sheeting Using a Modulated Infrared Sensor".

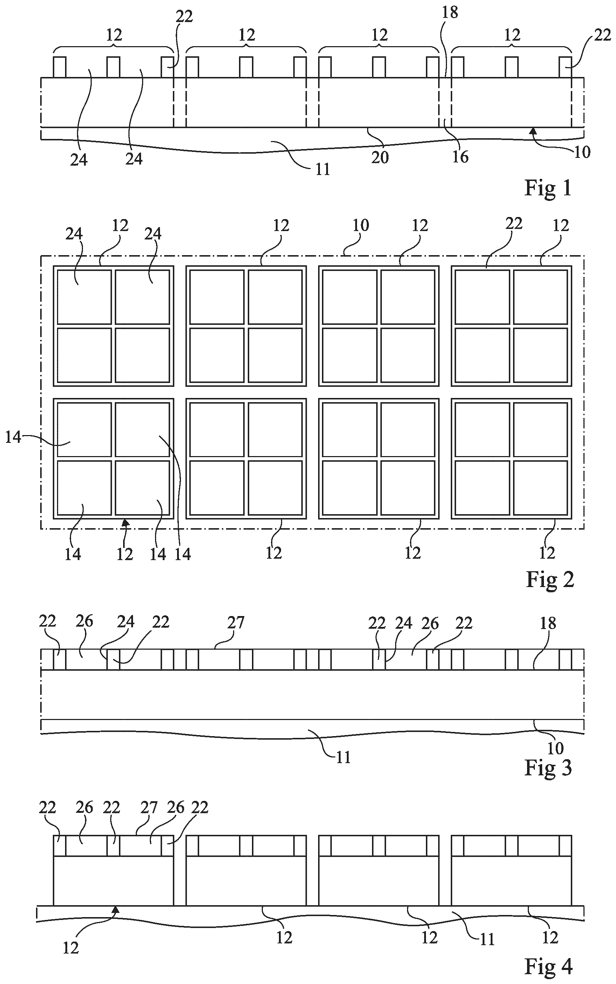

La figure 1 et la figure 2 sont respectivement une vue en coupe de côté et une vue de dessus, partielle et schématique, d'une structure obtenue à une étape d'un mode de réalisation d'un procédé de fabrication d'un dispositif optoélectronique correspondant à un écran d'affichage.

Selon un mode de réalisation, le procédé comprend la formation sur une plaque semiconductrice 10 de plusieurs exemplaires d'un pixel d'affichage 12, également appelé circuit de pixel d'affichage, pour un écran d'affichage. La plaque 10 peut reposer sur un support 11. A titre d'exemple, en figure 1, quatre exemplaires du pixel d'affichage 12 sont visibles et, en figure 2, huit exemplaires du pixel d'affichage 12 sont visibles. Chaque pixel d'affichage 12 comprend plusieurs sous-pixels d'affichage 14, par exemple trois ou quatre sous-pixels d'affichage 14. A titre d'exemple, comme cela est visible en figure 2, chaque pixel d'affichage 12 comprend quatre sous-pixels d'affichage 14. Chaque sous-pixel d'affichage 14 comprend une source lumineuse, non représentée, par exemple une diode électroluminescente. Selon un mode de réalisation, en vue de dessus, chaque pixel d'affichage 12 est inscrit dans un carrée dont le côté mesure de 4 µm à 2 mm. Selon un mode de réalisation, en vue de dessus, chaque sous-pixel d'affichage 14 est inscrit dans un carrée dont le côté mesure de 2 µm à 1,5 mm.

La plaque 10 comprend une structure principale 16 ayant une face supérieure 18 et une face inférieure 20 opposée à la face supérieure 18. Selon un mode de réalisation, les faces 18 et 20 sont parallèles. Selon un mode de réalisation, les faces 18 et 20 sont planes. La plaque 10 comprend, pour chaque pixel d'affichage 12, des murs 22 qui se projettent depuis la face supérieure 18 et délimitent une cavité 24 pour chaque sous-pixel d'affichage 14. Pour au moins certains sous-pixels d'affichage 14, la cavité 24 du sous-pixel d'affichage 14 est destinée à recevoir par exemple un module de conversion de couleur, par exemple un bloc photoluminescent comme cela sera décrit par la suite. Les murs 22 sont au moins en partie en un matériau réfléchissant ou absorbant le rayonnement émis par les sources lumineuses et les blocs photoluminescents du pixel d'affichage 12.

Selon un mode de réalisation, les murs 22 peuvent être formés d'un matériau réfléchissant ou d'un matériau recouvert d'un revêtement réfléchissant à la longueur d'onde du rayonnement émis par les blocs photoluminescents et/ou les diodes électroluminescentes. Le matériau réfléchissant peut être un matériau métallique notamment le fer, le cuivre, l'aluminium, le tungstène, l'argent, le titane, l'hafnium, le zirconium ou une combinaison d'au moins deux de ces composés. De préférence, les murs 22 sont formés en un matériau compatible avec les procédés de fabrication mis en oeuvre en microélectronique.

Selon un mode de réalisation, la hauteur des murs 22 mesurée par rapport à la face 18 est dans la plage de 300 nm à 200 µm, de préférence de 1 µm à 50 µm. Selon un mode de réalisation, l'épaisseur des murs 22, mesurée selon une direction parallèle à la face 18, est dans la plage de 100 nm à 50 µm, de préférence de 0,1 µm à 50 µm. Selon un mode de réalisation, le rapport d'aspect des murs 22, c'est-à-dire le rapport entre la hauteur et l'épaisseur des murs 22, est dans la plage de 0,5 à 20.

Selon un mode de réalisation, la fabrication des pixels d'affichage 12 de la plaque 10 met en oeuvre des techniques classiques en microélectronique. En particulier, selon un mode de réalisation, les murs 22 sont fabriqués par des techniques de dépôt et de gravure classiques en microélectronique, comprenant notamment des étapes de photolithographie. Ceci permet, de façon avantageuse, de réaliser des murs 22 dont l'épaisseur peut être de l'ordre du micromètre ou inférieure au micromètre.

Selon un mode de réalisation, la fabrication des murs 22 comprend le dépôt d'une couche du matériau composant le coeur des murs sur la totalité de la plaque 16 et la gravure de cette couche, par exemple une gravure sèche, pour délimiter les murs 22. Selon un mode de réalisation, la fabrication des murs 22 comprend le dépôt d'une couche de résine sur la plaque 16, la formation d'ouvertures dans la couche de résine aux emplacements souhaités des murs 22, le dépôt du matériau composant le coeur des murs 22 dans les ouvertures, et le retrait de la couche de résine. Le revêtement réfléchissant des murs 22 peut ensuite être réalisé.

La figure 3 est une vue en coupe de côté, partielle et schématique, de la structure obtenue après une étape de remplissage des cavités 24 par un matériau de remplissage temporaire de façon à former un bloc temporaire 26 dans chaque cavité 24. Les blocs temporaires 26 permettent notamment de consolider les cavités 24 pour des étapes ultérieures du procédé de fabrication. Selon un mode de réalisation, le matériau de remplissage temporaire est une résine photosensible. En figure 3, chaque bloc temporaire 26 est représenté s'étendant depuis la face supérieure 18 et s'arrêtant aux sommets des murs 22. A titre de variante, le matériau de remplissage temporaire peut remplir chaque cavité 24 et former une couche recouvrant les murs 22. La présence des blocs temporaires 26 permet l'obtention de pixels d'affichage 12 ayant une face supérieure 27 sensiblement plane. Selon un autre mode de réalisation, les blocs temporaires 26 ne sont pas présents.

La figure 4 est une vue en coupe de côté, partielle et schématique, de la structure obtenue après une étape de séparation des pixels d'affichage 12. L'étape de séparation des pixels d'affichage 12 peut comprendre la découpe de la plaque 10 par des techniques connues en microélectronique, par exemple par sciage.

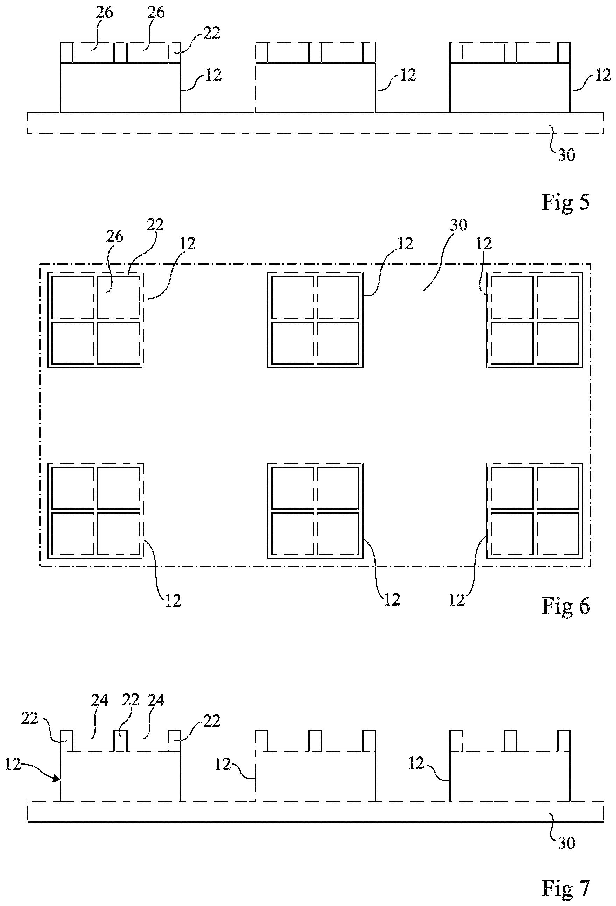

La figure 5 et la figure 6 sont respectivement une vue en coupe de côté et une vue de dessus, partielle et schématique, de la structure obtenue après une étape de placement d'au moins une partie des pixels d'affichage 12 sur un support 30, également appelé dalle, de l'écran d'affichage. Selon un mode de réalisation décrit plus en détails par la suite, le procédé de placement des pixels d'affichage 12 met en oeuvre un procédé de saisie et de placement (en anglais " pick and place ") dans lequel les pixels d'affichage 12 sont manipulés individuellement l'un après l'autre pour être placés à des emplacements souhaités sur la dalle 30, par exemple en utilisant un préhenseur. Selon un autre mode de réalisation décrit plus en détail par la suite, le procédé de manipulation des pixels d'affichage 12 met en oeuvre un procédé de transfert de masse dans lequel plusieurs pixels d'affichage 12 sont manipulés simultanément. Selon un mode de réalisation, la manipulation des pixels d'affichage 12 comprend l'exercice d'une force mécanique sur les murs 22 et/ou sur les blocs temporaires 26 du pixel d'affichage 12. La présence des blocs temporaires 26 permet de façon avantageuse l'obtention d'un pixel d'affichage 12 ayant une face supérieure plane, ce qui facilite l'utilisation d'un préhenseur.

A titre d'exemple, chaque pixel d'affichage 12 peut être fixé à la dalle 30 par collage moléculaire ou par l'intermédiaire d'un matériau de collage, notamment une colle époxy conductrice électriquement.

Selon un mode de réalisation, la dalle 30 comportant des pistes de connexion, non représentées, les pixels d'affichage 12 étant fixés aux pistes de connexion. Selon un mode de réalisation, le pas entre les pixels d'affichage 12 sur la dalle 30 est différent du pas entre les circuits de pixel d'affichage 12 sur la plaque 10.

La figure 7 est une vue en coupe de côté, partielle et schématique, de la structure obtenue après une étape de retrait des blocs temporaires 26 présents dans les cavités 24 de chaque pixel d'affichage 12. Le retrait des blocs temporaires 26 peut être réalisé par gravure humide ou gravure sèche.

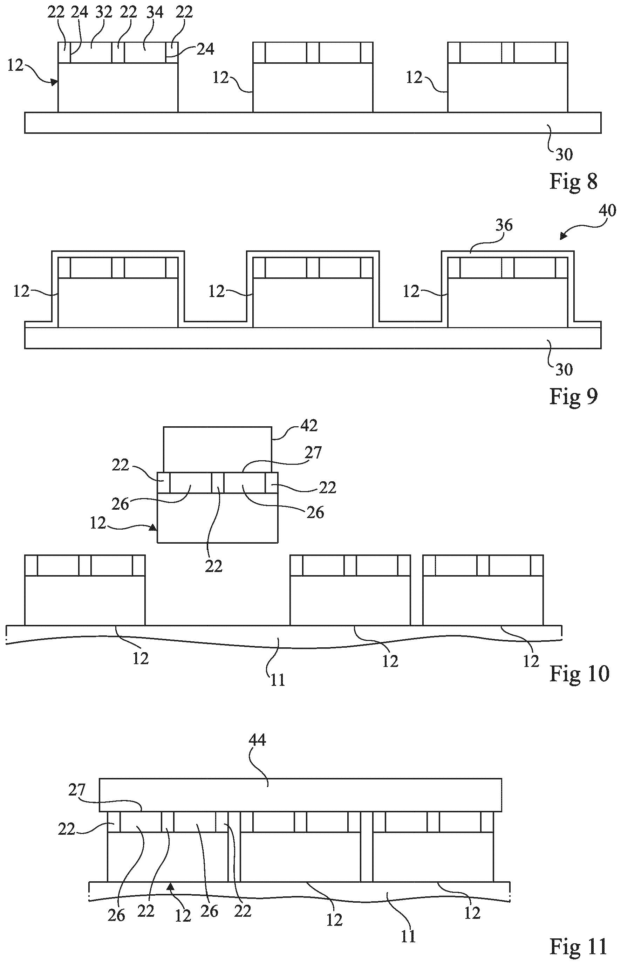

La figure 8 est une vue en coupe de côté, partielle et schématique, de la structure obtenue après une étape de remplissage, pour chaque pixel d'affichage 12, d'au moins certaines cavités 24 du pixel d'affichage 12, de préférence de chaque cavité 24 du pixel d'affichage 12, par un matériau de remplissage final. Le matériau de remplissage final peut ne pas être le même pour chaque cavité 24. Selon un mode de réalisation, pour au moins certaines des cavités 24 du pixel d'affichage 12, le matériau de remplissage final correspond par exemple à un matériau photoluminescent. Pour au moins certaines des cavités 24 du pixel d'affichage 12, il est alors formé un bloc photoluminescent 32 dans la cavité 24. Selon un mode de réalisation, pour au moins certaines des cavités 24 du pixel d'affichage 12, le matériau de remplissage final peut correspondre par exemple à un matériau non photoluminescent et transparent. Pour au moins certaines des cavités 24 du pixel d'affichage 12, il est alors formé un bloc transparent 34 dans la cavité 24.

Dans le mode de réalisation décrit précédemment en relation avec les figures 7 et 8, tous les blocs temporaires 26 sont retirés en même temps et ensuite tous les blocs photoluminescents 32 et les blocs transparents 34 sont formés. Selon un autre mode de réalisation, les blocs temporaires 26 peuvent ne pas être retirés tous en même temps mais des ensembles de blocs temporaires 26 peuvent être retirés à des étapes de retrait successives. Une étape de retrait d'un ensemble de blocs temporaires 26 est alors suivie d'une étape de formation de blocs photoluminescents 32 et/ou de blocs transparents 34 dans au moins certaines des cavités 24 libérées à l'étape de retrait précédente. Une étape de retrait d'un autre ensemble de blocs temporaires 26 suivie d'une étape de formation de blocs photoluminescents 32 et/ou de blocs transparents 34 dans au moins certaines des cavités 24 libérées sont alors mises en oeuvre, et ainsi de suite.

Selon un mode de réalisation, chaque bloc photoluminescent 32 ou bloc transparent 34, est situé en vis-à-vis de l'une des diodes électroluminescentes ou d'un ensemble de diodes électroluminescentes. Chaque bloc photoluminescent 32 comprend des luminophores ou des particules d'au moins un matériau photoluminescent adaptés, lorsqu'ils sont excités par la lumière émise par la diode électroluminescente associée, à émettre de la lumière à une longueur d'onde différente de la longueur d'onde de la lumière émise par la diode électroluminescente associée. Selon un mode de réalisation, le pixel d'affichage 12 comprend au moins deux types de blocs photoluminescents 32. Chaque bloc photoluminescent 32 du premier type est adapté à convertir le rayonnement fourni par les diodes électroluminescentes qu'il recouvre en un premier rayonnement à une première longueur d'onde et chaque bloc photoluminescent 32 du deuxième type est adapté à convertir le rayonnement fourni par les diodes électroluminescentes qu'il recouvre en un deuxième rayonnement à une deuxième longueur d'onde. Selon un mode de réalisation, le pixel d'affichage comprend au moins trois types de blocs photoluminescents 32, le bloc photoluminescent du troisième type étant adapté à convertir le rayonnement fourni par les diodes électroluminescentes qu'il recouvre en un troisième rayonnement à une troisième longueur d'onde. Les première, deuxième et troisième longueurs d'ondes peuvent être différentes.

Selon un mode de réalisation, les diodes électroluminescentes des pixels 12 sont adaptées à émettre de la lumière bleue, c'est-à-dire un rayonnement dont la longueur d'onde est dans la plage de 430 nm à 490 nm. Selon un mode de réalisation, la première longueur d'onde correspond à de la lumière verte et est dans la plage de 510 nm à 570 nm. Selon un mode de réalisation, la deuxième longueur d'onde correspond à de la lumière rouge et est dans la plage de 600 nm à 720 nm.

Selon un autre mode de réalisation, les diodes électroluminescentes des pixels 12 sont adaptées à émettre un rayonnement dans l'ultraviolet. Selon un mode de réalisation, la première longueur d'onde correspond à de la lumière bleue et est dans la plage de 430 nm à 490 nm. Selon un mode de réalisation, la deuxième longueur d'onde correspond à de la lumière verte et est dans la plage de 510 nm à 570 nm. Selon un mode de réalisation, la troisième longueur d'onde correspond à de la lumière rouge et est dans la plage de 600 nm à 720 nm.

Selon un mode de réalisation, chaque bloc photoluminescent 32 comprend une matrice dans laquelle sont dispersées des particules photoluminescentes monocristallines de taille nanométrique d'un matériau semiconducteur, également appelées nanocristaux semiconducteurs ou particules de nanoluminophores par la suite. Le rendement quantique interne QYᵢₙₜ d'un matériau photoluminescent est égal au rapport entre le nombre de photons émis et le nombre de photons absorbés par la substance photoluminescente. Le rendement quantique interne QYᵢₙₜ des nanocristaux semiconducteurs est supérieur à 5 %, de préférence supérieur à 10 %, plus préférentiellement supérieur à 20 %.

Selon un mode de réalisation, la taille moyenne des nanocristaux est dans la plage de 0,5 nm et 1000 nm, de préférence de 0,5 nm à 500 nm, encore plus préférentiellement de 1 nm à 100 nm, notamment de 2 nm à 30 nm. Pour des dimensions inférieures à 50 nm, les propriétés de photoconversion des nanocristaux semiconducteurs dépendent essentiellement de phénomènes de confinement quantique sensiblement tridimensionnel. Les nanocristaux semiconducteurs correspondent alors à des boîtes quantiques.

Selon un mode de réalisation, le matériau semiconducteur des nanocristaux semiconducteurs est choisi parmi le groupe comprenant le séléniure de cadmium (CdSe), le phosphure d'indium (InP), le sulfure de cadmium (CdS), le sulfure de zinc (ZnS), le séléniure de zinc (ZnSe), le tellurure de cadmium (CdTe), le tellurure de zinc (ZnTe), l'oxyde de cadmium (CdO), l'oxyde de zinc et de cadmium (ZnCdO), le sulfure de zinc et de cadmium (CdZnS), le séléniure de zinc et de cadmium (CdZnSe), le sulfure d'argent et d'indium (AgInS₂), les pérovskites du type PbScX₃, où X est un atome d'halogène, notamment l'iode (I), le brome (Br) ou le chlore (Cl), et un mélange d'au moins deux de ces composés. Selon un mode de réalisation, le matériau semiconducteur des nanocristaux semiconducteurs est choisi parmi les matériaux cités dans la publication au nom de Le Blevenec et al. de Physica Status Solidi (RRL) - Rapid Research Letters Volume 8, No. 4, pages 349-352, avril 2014.

Selon un mode de réalisation, les dimensions des nanocristaux semiconducteurs sont choisies selon la longueur d'onde recherchée du rayonnement émis par les nanocristaux semiconducteurs. A titre d'exemple, des nanocristaux de CdSe dont la taille moyenne est de l'ordre de 3,6 nm sont adaptés à convertir de la lumière bleue en lumière rouge et des nanocristaux de CdSe dont la taille moyenne est de l'ordre de 1,3 nm sont adaptés à convertir de la lumière bleue en lumière verte. Selon un autre mode de réalisation, la composition des nanocristaux semiconducteurs est choisie selon la longueur d'onde recherchée du rayonnement émis par les nanocristaux semiconducteurs.

La matrice des blocs photoluminescents 32 est transparente au rayonnement émis par les particules photoluminescentes et/ou les diodes électroluminescentes LED, de préférence à plus de 80 %. La matrice est, par exemple, en silice. La matrice est, par exemple, en n'importe quel polymère au moins en partie transparent, notamment en silicone, en époxy, en résine acrylique du type poly(méthacrylate de méthyle) (PMMA), ou en acide polyacétique (PLA). La matrice peut notamment être en un polymère au moins en partie transparent utilisé avec les imprimantes tridimensionnelles. La matrice peut correspondre à un verre déposé par centrifugation (SOG, sigle anglais pour Spin On Glass), photosensible ou non photosensible. Selon un mode de réalisation, la matrice contient de 2 % à 90 %, de préférence de 10 % à 60 %, en poids de nanocristaux, par exemple environ 30 % en poids de nanocristaux. Selon un mode de réalisation, les blocs transparents 34 comprennent seulement la matrice telle que décrite précédemment.

L'épaisseur des blocs photoluminescents 32 dépend de la concentration de nanocristaux et du type de nanocristaux utilisé. La hauteur des blocs photoluminescents 32 est inférieure ou égale à la hauteur des murs 22. En vue de dessus, chaque bloc photoluminescent 32 peut correspondre à un carré, un rectangle, un polygone en forme de "L", etc., dont l'aire peut être égale à l'aire d'un carré ayant un côté mesurant de 1 µm à 100 µm, de préférence de 3 µm à 15 µm. Le rapport d'aspect des blocs 32, c'est-à-dire le rapport entre la hauteur et la largeur maximale du bloc, peut être compris entre 0,01 et 10, de préférence entre 0,05 et 2.

Les murs 22, qui entourent les blocs photoluminescents 32 et les blocs transparents 34, permettent, de façon avantageuse, de réduire la diaphonie optique entre sous-pixels d'affichage adjacents.

Selon un mode de réalisation, le remplissage des cavités 24 par le matériau de remplissage final est réalisé par impression par jet d'encre, notamment par impression par jet électrodynamique, par impression par jet d'aérosol, ou par impression par extrusion.

Le fait de former les blocs photoluminescents 32 et les blocs transparents 34 après la mise en place des pixels d'affichage 12 sur la dalle 30 permet de façon avantageuse de pouvoir sélectionner le matériau de remplissage à utiliser à une étape tardive de la fabrication du dispositif optoélectronique. En outre, les étapes de fabrication des pixels d'affichage 12 et de mise en place des pixels d'affichage 12 sur la dalle 30 peuvent être communes pour différents types de dispositifs optoélectroniques pour lesquels les blocs photoluminescents 32 sont différents.

Un autre avantage de former les blocs photoluminescents 32 et les blocs transparents 34 après la mise en place des pixels d'affichage 12 sur la dalle 30 est que les blocs photoluminescents 32 ne sont pas exposés à des températures élevées qui peuvent être présentes notamment lors de la fixation des pixels d'affichage 32 à la dalle 30.

Un autre avantage de former les blocs photoluminescents 32 et les blocs transparents 34 après la mise en place des pixels d'affichage 12 sur la dalle 30 est qu'il n'est pas nécessaire de prévoir une protection des blocs photoluminescents 32 qui serait nécessaire si les blocs photoluminescents 32 étaient formés avant la séparation des pixels d'affichage 12 ou avant la mise en place des pixels d'affichage 12 sur la dalle 30.

La figure 9 est une vue en coupe de côté, partielle et schématique, de la structure obtenue après une étape de formation d'un film de protection 36 sur l'ensemble des pixels d'affichage 12 et sur la dalle 30 entre les pixels d'affichage 12. Selon un mode de réalisation, le film de protection 36 est étanche à l'eau et à l'oxygène. Selon un mode de réalisation, le film de protection 36 est déposé par lamination. L'écran d'affichage 40 est ainsi obtenu. Selon un mode de réalisation, le film de protection 36 recouvre la face supérieure et les flancs latéraux de chaque pixel 12 et est au contact physique direct de la face supérieure et les flancs latéraux de chaque pixel 12.

Le film de protection 36 est transparent au rayonnement émis par les blocs photoluminescents 32 et/ou les diodes électroluminescentes. Le film de protection 36 peut être réalisé en un matériau inorganique transparent au rayonnement émis par les blocs photoluminescents et/ou les diodes électroluminescentes. A titre d'exemple, le matériau inorganique est choisi parmi le groupe comprenant les oxydes de silicium, du type SiOₓ où x est un nombre réel compris entre 1 et 2 ou SiO_{y}N_{z} où y et z sont des nombres réels compris entre 0 et 1, l'oxyde de titane, les oxydes d'aluminium, par exemple Al₂O₃, et les mélanges de ces composés. Le film de protection 36 peut être réalisé en un matériau organique au moins partiellement transparent. A titre d'exemple, le film de protection 36 est un polymère silicone, un polymère époxyde, un polymère acrylique ou un polycarbonate. Le film de protection 36 peut avoir une structure monocouche ou multicouches, et comprendre par exemple un empilement de couches organiques et/ou inorganiques. Selon un mode de réalisation, l'épaisseur du film de protection 36 est comprise entre 10 nm et 1 mm. Le film de protection 36 peut avoir une structure multicouches avec des couches organiques et/ou inorganiques.

La figure 10 est une vue en coupe de côté, partielle et schématique, illustrant un mode de réalisation d'un procédé de transfert des pixels d'affichage 12 du type saisie et placement (en anglais pick and place). Les pixels d'affichage 12 obtenus après l'étape de découpe de la plaque 10 décrite précédemment en relation avec la figure 4 sont manipulés individuellement l'un après l'autre pour être placés à des emplacements souhaités sur la dalle 30, non représentée en figure 10, par exemple en utilisant un préhenseur 42.

La figure 11 est une vue en coupe de côté, partielle et schématique, illustrant un mode de réalisation d'un procédé de transfert des pixels d'affichage 12 du type transfert de masse. Plusieurs pixels d'affichage 12 sont saisis simultanément par un préhenseur 44, par exemple un tampon élastomère, pour être placés sur la dalle 30, non représentée en figure 11.

Selon un mode de réalisation, la manipulation des pixels d'affichage 12 comprend l'exercice d'une force mécanique sur les murs 22 et/ou sur les blocs temporaires 26 du pixel d'affichage 12. La présence des blocs temporaires 26 permet de façon avantageuse l'obtention d'un pixel d'affichage 12 ayant une face supérieure 27 sensiblement plane, ce qui facilite l'utilisation d'un préhenseur. Toutefois, à titre de variante, les blocs temporaires 26 peuvent ne pas être présents. La manipulation des pixels d'affichage 12 peut alors comprendre l'exercice d'une force mécanique seulement sur les murs 22 du pixel d'affichage 12.

Selon un mode de réalisation, la fixation du pixel d'affichage 12 au préhenseur 42 ou des pixels d'affichage 12 au préhenseur 44 peut comprendre l'exercice d'une pression du préhenseur 42 sur le pixel d'affichage 12 ou du préhenseur 44 sur les pixels d'affichage 12, éventuellement tout en maintenant le préhenseur 42 ou 44 dans une plage de températures donnée et/ou en exposant le préhenseur 42 ou 44 à un rayonnement donné. Selon un mode de réalisation, la séparation du pixel d'affichage 12 par rapport au préhenseur 42 ou des pixels d'affichage 12 par rapport au préhenseur 44 peut comprendre l'exercice d'une traction sur le préhenseur 42 ou 44, éventuellement tout en maintenant le préhenseur 42 ou 44 dans une plage de températures donnée et/ou en exposant le préhenseur 42 ou 44 à un rayonnement donné.

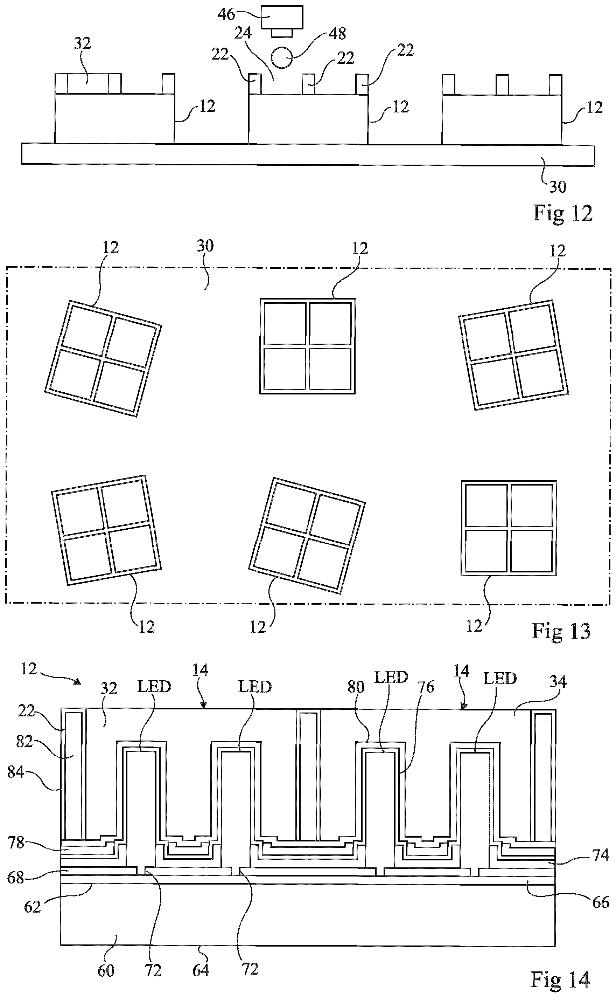

La figure 12 est une vue en coupe de côté, partielle et schématique, illustrant un mode de réalisation d'un procédé de formation des blocs photoluminescents 32 et des blocs transparents 34 par impression par jet d'encre. Selon un mode de réalisation, une tête d'impression 46 d'une imprimante à jet d'encre est déplacée jusqu'à venir à l'aplomb de chaque cavité 24 destinée à contenir un bloc photoluminescent 32 de façon à éjecter une goutte 48 ou des gouttes du matériau de remplissage final dans la cavité 24 pour remplir la cavité 24 du matériau de remplissage final.

La figure 13 est une vue analogue à la figure 6 illustrant une configuration dans laquelle au moins certains des pixels d'affichage 12 sont disposés sur la dalle 30 à une position et/ou selon une orientation qui ne sont pas exactement la position et/ou l'orientation idéales souhaitées. De façon avantageuse, les procédés de remplissage des cavités 24 sont adaptés à compenser les écarts entre la position et/ou l'orientation réelles du pixel d'affichage 12 et la position et/ou l'orientation idéales souhaitées. A titre d'exemple, une imprimante à jet d'encre comprend un système de guidage configuré pour ajuster la position de la tête d'impression 46 pour tenir compte d'un écart entre la position et/ou de l'orientation réelles du pixel d'affichage 12 et la position et/ou l'orientation idéales souhaitées du pixel d'affichage 12 pour que la goutte 48 ou les gouttes soient éjectées correctement dans la cavité 24.

Un avantage de former les murs 22 avant l'étape de transfert des circuits de pixel d'affichage sur la dalle 30 et que cela rend plus facile la réalisation des murs 22 par des étapes de fabrication comprenant des étapes de photolithographie car les pixels d'affichage 12 n'ont pas encore subi de transfert et sont donc correctement alignés sur la plaque 10. En effet, le transfert induit de potentiels défauts de décalages ou rotation de positionnement qui rendent la mise en oeuvre d'étapes de photolithographie pour former les murs 22 impossible, complexe ou imprécise car devant prendre en compte des degrés d'erreur multiples. A titre d'exemple, la réalisation d'un masque pour réaliser les murs 22 après le transfert devra tenir compte de l'ensemble des erreurs qu'on peut voir sur l'exemple de la figure 13 et la conception des pixels d'affichage 12 devra être revue dans son ensemble pour pouvoir s'adapter, nécessitant à l'évidence pour une même surface utile émissive, des pixels d'affichage plus grands et une plus grande quantité de matière pour former les murs.

Selon un mode de réalisation, chaque pixel d'affichage 12 comprend au moins une diode électroluminescente. Selon un mode de réalisation, chaque pixel d'affichage 12 comprend des diodes électroluminescentes formées à partir d'éléments tridimensionnels de taille nanométrique ou micrométrique, en particulier des microfils, des nanofils ou des pyramides.

Le terme "microfil" ou "nanofil" désigne une structure tridimensionnelle de forme allongée selon une direction privilégiée dont au moins deux dimensions, appelées dimensions mineures, sont comprises entre 5 nm et 5 µm, de préférence entre 100 nm et 2 µm, plus préférentiellement entre 200 nm et 1,5 µm, la troisième dimension, appelée dimension majeure ou hauteur, étant supérieure ou égale à 1 fois, de préférence supérieure ou égale à 3 fois et encore plus préférentiellement supérieure ou égale à 5 fois, la plus grande des dimensions mineures. Dans certains modes de réalisation, la hauteur de chaque microfil ou nanofil peut être supérieure ou égale à 500 nm, de préférence comprise entre 1 µm et 50 µm. Dans la suite de la description, on utilise le terme "fil" pour signifier "microfil ou nanofil".

La section droite des fils peut avoir différentes formes, par exemple, une forme ovale, circulaire ou polygonale, notamment triangulaire, rectangulaire, carrée ou hexagonale. On comprendra que le terme "diamètre moyen" utilisé en relation avec une section droite d'un fil désigne une quantité associée avec l'aire du fil dans cette section droite, correspondant, par exemple, au diamètre du disque ayant la même aire que la section droite du fil.

Dans la suite de la description, le terme pyramide désigne une structure tridimensionnelle dont une partie est de forme pyramidale ou conique allongée. Cette structure pyramidale peut être tronquée, c'est-à-dire que le haut du cône est absent, laissant place à un plateau. La base de la pyramide est inscrite dans un carré dont la dimension des côtés est de 100 nm à 10 µm, préférentiellement entre 0,2 µm et 2 µm. Le polygone formant la base de la pyramide peut être un hexagone. La hauteur de la pyramide entre la base de la pyramide et le sommet ou le plateau sommital varie de 100 nm à 20 µm, préférentiellement entre 200 nm et 2 µm.

Dans la suite de la description, des modes de réalisation vont être décrits dans le cas d'un pixel d'affichage 12 à diodes électroluminescentes comprenant des microfils ou nanofils. Toutefois, il est clair que ces modes de réalisation peuvent concerner un pixel d'affichage à diodes électroluminescentes comprenant des pyramides de taille micrométrique ou nanométrique.

Les fils comprennent en majorité, de préférence à plus de 60 % en masse, plus préférentiellement à plus de 80 % en masse, au moins un matériau semiconducteur. Le matériau semiconducteur peut être du silicium, du germanium, du carbure de silicium, un composé III-V, un composé II-VI ou une combinaison d'au moins deux de ces composés.

Des exemples d'éléments du groupe III comprennent le gallium (Ga), l'indium (In) ou l'aluminium (Al). Des exemples de composés III-N sont GaN, AlN, InN, InGaN, AlGaN ou AlInGaN. D'autres éléments du groupe V peuvent également être utilisés, par exemple, le phosphore ou l'arsenic. De façon générale, les éléments dans le composé III-V peuvent être combinés avec différentes fractions molaires. Des exemples d'éléments du groupe II comprennent des éléments du groupe IIA, notamment le béryllium (Be) et le magnésium (Mg) et des éléments du groupe IIB, notamment le zinc (Zn), le cadmium (Cd) et le mercure (Hg). Des exemples d'éléments du groupe VI comprennent des éléments du groupe VIA, notamment l'oxygène (O) et le tellure (Te). Des exemples de composés II-VI sont ZnO, ZnMgO, CdZnO, CdZnMgO, CdHgTe, CdTe ou HgTe. De façon générale, les éléments dans le composé II-VI peuvent être combinés avec différentes fractions molaires. Le matériau semiconducteur des fils peut comporter un dopant, par exemple du silicium assurant un dopage de type N d'un composé III-N, ou du magnésium assurant un dopage de type P d'un composé III-N.

La figure 14 est une vue en coupe, partielle et schématique, d'un mode de réalisation plus détaillé du pixel d'affichage 12 dans le cas d'un pixel d'affichage 12 à diodes électroluminescentes à nanofils ou microfils. Le pixel d'affichage 12 comprend de bas en haut en figure 14 :
- un substrat 60 comprenant des faces opposées 62 et 64, la face supérieure 62 étant de préférence plane au moins au niveau des diodes électroluminescentes ;
- une couche de germination 66 en un matériau favorisant la croissance de fils et disposée sur la face 62 ;
- une couche isolante 68 recouvrant la couche de germination 66 et comprenant des ouvertures 72 exposant des portions de la couche de germination 66 ;
- des diodes électroluminescentes LED (quatre diodes électroluminescentes étant représentées), chaque diode électroluminescente LED étant en contact avec la couche de germination 66 au travers de l'une des ouvertures 72 ;
- une couche isolante 74 s'étendant sur les flancs latéraux d'une portion inférieure de chaque diode électroluminescente LED et s'étendant sur la couche isolante 68 entre les diodes électroluminescentes LED ;
- une couche 76 formant une électrode recouvrant chaque diode électroluminescente LED et s'étendant en outre sur la couche isolante 74 entre les diodes électroluminescentes LED ;
- une couche conductrice 78 et réfléchissante, s'étendant sur la couche 76 entre les diodes électroluminescentes LED, la couche conductrice 78 pouvant, à titre de variante, être interposée entre la couche d'électrode 76 et la couche isolante 74 entre les diodes électroluminescentes LED ;
- une couche 80 de protection diélectrique s'étendant sur les couches 76 et 78 ;
- les blocs photoluminescents 32 recouvrant certains ensembles de diodes électroluminescentes, un seul bloc photoluminescent 32 étant représenté à titre d'exemple en figure 14 ;
- les blocs transparents 34 au rayonnement émis par les diodes électroluminescentes et recouvrant d'autres ensembles de diodes électroluminescentes, les blocs transparents 34 pouvant ne pas être présents, un seul bloc transparent 34 étant représenté à titre d'exemple en figure 14 ; et
- les murs 22 autour des blocs 32, 34, chaque mur 22 comprenant ici un coeur 82 entouré d'un revêtement 84 réfléchissant.

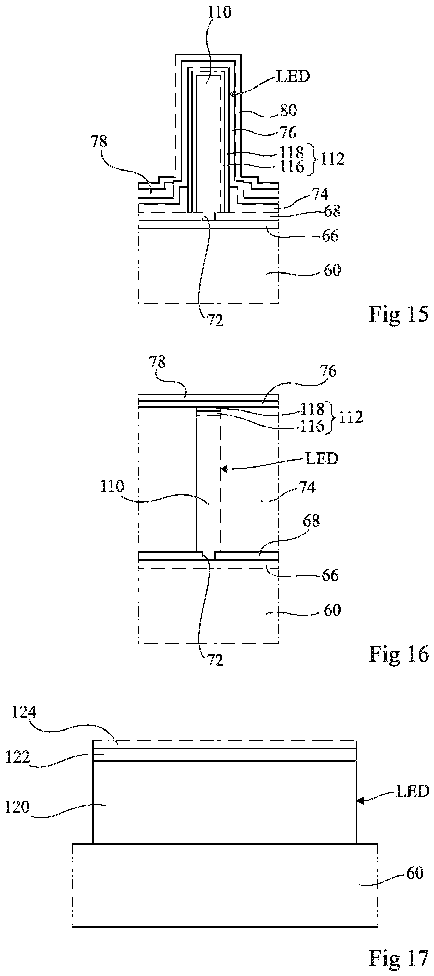

La figure 15 représente un mode de réalisation des diodes électroluminescentes LED dans lequel chaque diode électroluminescente LED comprend un fil 110 en contact avec la couche de germination 66 au travers de l'une des ouvertures 72 et une coque 112 comprenant un empilement de couches semiconductrices recouvrant les parois latérales et le sommet du fil 110. Une telle configuration est dite radiale. L'ensemble formé par chaque fil 110 et la coque 112 associée constitue la diode électroluminescente LED. Selon un autre mode de réalisation, la couche de germination 66 peut être remplacée par des plots de germination, par exemple formés au fond des ouvertures 72.

La coque 112 peut comprendre un empilement de plusieurs couches comprenant notamment une couche active 116 et une couche de liaison 118. La couche active 116 est la couche depuis laquelle est émise la majorité, de préférence la totalité, du rayonnement fourni par la diode électroluminescente LED. Selon un exemple, la couche active 116 peut comporter des moyens de confinement, tels qu'un puits quantique unique ou des puits quantiques multiples. La couche de liaison 118 peut comprendre un empilement de couches semiconductrices du même matériau III-V que le fil 110 mais du type de conductivité opposé au fil 110.

La figure 16 représente un autre mode de réalisation des diodes électroluminescentes LED. La diode électroluminescente LED représentée en figure 16 comprend l'ensemble des éléments de la diode électroluminescente LED représentée en figure 15 à la différence que la coque 112 n'est présente qu'au sommet du fil 110. Une telle configuration est dite axiale.

La formation des diodes électroluminescentes LED, c'est-à-dire la croissance des fils 110 dans les ouvertures 72, et la formation des coques 112 recouvrant les fils 110 peut être réalisée par exemple par dépôt chimique en phase vapeur organométallique (MOCVD, acronyme anglais pour Metal-Organic Chemical Vapor Déposition) ou tout autre procédé adapté.

Le substrat 60 peut correspondre à une structure monobloc ou correspondre à une couche recouvrant un support constitué d'un autre matériau. Le substrat 60 est de préférence un substrat semiconducteur, par exemple un substrat en silicium, en germanium, en carbure de silicium, en un composé III-V, tel que du GaN ou du GaAs, ou un substrat en ZnO. De préférence, le substrat 60 est un substrat de silicium monocristallin. Le substrat 60 peut correspondre à une structure multicouches de type silicium sur isolant, également appelée SOI (acronyme anglais pour Silicon On Insulator).

La couche de germination 66 est en un matériau favorisant la croissance des fils. A titre d'exemple, le matériau composant la couche de germination 66 peut être un nitrure, un carbure ou un borure d'un métal de transition de la colonne IV, V ou VI du tableau périodique des éléments ou une combinaison de ces composés. Selon un autre mode de réalisation, la couche de germination 66 peut ne pas être présente.

Chaque couche isolante 68, 74, 80 peut être en un matériau diélectrique, par exemple en oxyde de silicium (SiO₂), en nitrure de silicium (SiₓN_{y}, où x est environ égal à 3 et y est environ égal à 4, par exemple du Si₃N₄), en oxynitrure de silicium (notamment de formule générale SiOₓN_{y}, par exemple du Si₂ON₂), en oxyde d'aluminium (Al₂O₃), en oxyde d'hafnium (HfO₂), en dioxyde de titane (TiO₂) ou en diamant. Chaque couche isolante 68, 74, 80 peut avoir une structure monocouche ou correspondre à un empilement de deux couches ou de plus de deux couches.

La couche d'électrode 76 est adaptée à laisser passer le rayonnement électromagnétique émis par les diodes électroluminescentes. Le matériau formant la couche d'électrode 76 peut être un matériau transparent et conducteur tel que de l'oxyde d'indium-étain (ou ITO, acronyme anglais pour Indium Tin Oxide), ou de l'oxyde de zinc dopé à l'aluminium ou au gallium. L'épaisseur de la couche d'électrode 76 peut être comprise entre 0,01 µm et 1 µm.

La couche conductrice 78 correspond, de préférence à une couche métallique, par exemple en aluminium, en argent, en cuivre, en or ou en zinc. L'épaisseur de la couche conductrice 78 peut être comprise entre 0,01 µm et 10 µm.

La figure 17 représente un autre mode de réalisation des diodes électroluminescentes LED. La diode électroluminescente LED représentée en figure 17 a une structure bidimensionnelle dans la mesure où elle est fabriquée par la formation d'un empilement de couches semiconductrices sensiblement planes sur le substrat 60 suivie de la délimitation de la diode électroluminescente, par exemple par gravure de tranchées dans l'empilement de couches semiconductrices. La diode électroluminescente représentée en figure 17 comprend une couche semiconductrice 120 dopée d'un premier type de conductivité, recouverte d'une couche active 122, elle-même recouverte d'une couche semiconductrice 124 dopée d'un deuxième type de conductivité.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Procédé de fabrication d'un dispositif optoélectronique (40) comprenant les étapes suivantes, dans l'ordre :
a) fabriquer des circuits de pixel d'affichage (12) comprenant chacun une face (18) d'émission, et sur ladite face (18), des murs (22) délimitant au moins une cavité (24) ;
b) fixer lesdits circuits de pixel d'affichage (12) à un support (30) ; et
c) remplir ladite au moins une cavité (24) de chaque circuit de pixel d'affichage (12) par un premier matériau de remplissage pour former un premier module de conversion de couleur (32) .

2. Procédé selon la revendication 1, dans lequel ledit premier matériau de remplissage comprend des boîtes quantiques.

3. Procédé selon la revendication 1 ou 2, comprenant, après l'étape c), l'étape de formation d'un film de protection (36) recouvrant complètement chaque circuit de pixel d'affichage (12) et ledit support (30) entre lesdits circuits de pixel d'affichage (12).

4. Procédé selon l'une quelconque des revendications 1 à 3, dans lequel l'étape a) comprend la formation de plusieurs exemplaires dudit circuit de pixel d'affichage (12) sur une plaque (10) et la découpe de ladite plaque (10) pour séparer lesdits circuits de pixel d'affichage (12) .

5. Procédé selon la revendication 4, dans lequel, à l'étape a), la formation desdits murs (22) comprend des étapes de photolithographie.

6. Procédé selon la revendication 4 ou 5, comprenant, à l'étape a), le remplissage desdites cavités (24) par un deuxième matériau de remplissage (26) et, après l'étape b) et avant l'étape c), le retrait dudit deuxième matériau de remplissage desdites cavités (24).

7. Procédé selon l'une quelconque des revendications 1 à 6, dans lequel, à l'étape c), le remplissage de ladite au moins une cavité (24) de chaque circuit de pixel d'affichage (12) par ledit premier matériau de remplissage est réalisé par impression par jet d'encre, par impression par jet d'aérosol, ou par impression par extrusion.

8. Procédé selon l'une quelconque des revendications 1 à 7, dans lequel, à l'étape a), lesdits murs (22) délimitent au moins trois cavités (24) pour chaque circuit de pixel d'affichage (12).

9. Procédé selon l'une quelconque des revendications 1 à 8, dans lequel lesdits murs (22) délimitent au moins deux cavités (24) pour chaque circuit de pixel d'affichage (12), et dans lequel l'étape c) comprend le remplissage d'au moins l'une des cavités (24) de chaque circuit de pixel d'affichage (12) par un troisième matériau de remplissage, différent dudit premier matériau de remplissage, pour former un deuxième module de conversion de couleur (32) dans ladite cavité (24).

10. Procédé selon l'une quelconque des revendications 1 à 9, dans lequel le rapport entre la hauteur et l'épaisseur desdits murs (22) est dans la plage de 0,5 à 50.

11. Procédé selon l'une quelconque des revendications 1 à 10, comprenant, à l'étape a), la formation de diodes électroluminescentes (LED) pour chaque circuit de pixel d'affichage (12).

12. Procédé selon l'une quelconque des revendications 4 à 6, dans lequel ledit support (30) comprend une dalle munie de pistes électriques de connexion, le procédé comprenant, à l'étape b), le transfert desdits circuits de pixel d'affichage (12) sur ladite dalle (30), lesdits circuits de pixel d'affichage (12) étant fixés auxdites pistes électriques de connexion, le pas entre lesdits circuits de pixel d'affichage (12) sur ladite dalle (30) étant différent du pas entre lesdits circuits de pixel d'affichage (12) sur ladite plaque (10).

13. Procédé selon l'une quelconque des revendications 1 à 12, dans lequel ledit dispositif optoélectronique (40) est un écran d'affichage.

14. Ecran d'affichage (40) obtenu par le procédé de fabrication selon l'une quelconque des revendications 1 à 13.
